(19) Europäisches Patentamt / European Patent Office / Office européen des brevets

(11) **EP 3 052 952 B1**

(12) **FASCICULE DE BREVET EUROPEEN**

(45) Date de publication et mention de la délivrance du brevet:
**15.11.2017 Bulletin 2017/46**

(51) Int Cl.:
***G01R 31/36*** *(2006.01)*

(21) Numéro de dépôt: **14777615.7**

(22) Date de dépôt: **30.09.2014**

(86) Numéro de dépôt international:
**PCT/EP2014/070983**

(87) Numéro de publication internationale:
**WO 2015/044460 (02.04.2015 Gazette 2015/13)**

(54) **PROCÉDÉ DE SURVEILLANCE D'UNE BATTERIE LI-ION ET DISPOSITIF DE SURVEILLANCE POUR SA MISE EN OEUVRE**

VERFAHREN ZUR ÜBERWACHUNG EINER LI-IONENBATTERIE UND ÜBERWACHUNGSVORRICHTUNG ZUR IMPLEMENTIERUNG DAVON

METHOD FOR MONITORING A LI-ION BATTERY AND MONITORING DEVICE FOR IMPLEMENTATION OF SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2013 FR 1359428**

(43) Date de publication de la demande:
**10.08.2016 Bulletin 2016/32**

(73) Titulaires:
• **Commissariat à l'Énergie Atomique et aux Énergies Alternatives**
**75015 Paris (FR)**
• **Université Grenoble Alpes**
**38400 Saint-Martin-d'Hères (FR)**
• **Institut Polytechnique de Grenoble**
**38000 Grenoble (FR)**

(72) Inventeurs:
• **KIRCHEVA, Nina**
**F-73100 Aix Les Bains (FR)**
• **THIVEL, Pierre-Xavier**
**F-38000 Grenoble (FR)**
• **GENIES, Sylvie**
**F-38120 Saint Egreve (FR)**
• **ALIAS, Mélanie**
**F-77167 Poligny (FR)**
• **HING, Sothun Eric**
**73000 Chambery (FR)**

(74) Mandataire: **Novaimo**
**ActiTech 8**
**60 avenue Marie Curie**
**Archamps Technopole**
**74166 Saint Julien-en-Genevois Cedex (FR)**

(56) Documents cités:
**WO-A1-2012/146704      US-A1- 2012 304 771**
**US-A1- 2013 091 950**

• **Nina Kircheva ET AL: "Acoustic Methods as a Tool for Management of Electrochemical Process of Energy", 30th European Conference on Acoustic Emission Testing & 7th International Conference on Acoustic Emission, 12 septembre 2012 (2012-09-12), pages 1-10, XP055125586, Extrait de l'Internet: URL:http://www.ndt.net/article/ewgae2012/content/papers/29_Thivel.pdf [extrait le 2014-06-27]**
• **AURÉLIEN ETIEMBLE ET AL: "On the Use of the Acoustic Emission Technique for In-situ Monitoring of the Pulverization of Battery Electrodes", 30TH EUROPEAN CONFERENCE ON ACOUSTIC EMISSION TESTING & 7TH INTERNATIONAL CONFERENCE ON ACOUSTIC EMISSION, 12 septembre 2012 (2012-09-12), pages 1-9, XP055125591,**

- "Use of Acoustic Emissions for Understanding Degradation in Anode Materials for Lithium Ion Batteries", , 1 décembre 2009 (2009-12-01), pages 1-2, XP055125589, Extrait de l'Internet: URL:http://web.ornl.gov/sci/physical_scien ces_directorate/mst/mpg/pdf/Acoustic_emiss .p df [extrait le 2014-06-27]

- SHOGO KOMAGATA ET AL: "Detection of Degradation of Lithium-Ion Batteries with Acoustic Emission Technique", ECS TRANSACTIONS, 1 janvier 2010 (2010-01-01), pages 163-167, XP055125594, ISSN: 1938-5862, DOI: 10.1149/1.3334804

**Description**

La présente invention concerne le domaine des batteries d'accumulateurs de type lithium-ion ou Li-ion. En particulier, l'invention concerne un procédé de surveillance d'une cellule électrochimique ou d'une batterie. L'invention porte encore sur un dispositif de surveillance mettant en oeuvre le procédé de surveillance.

L'invention est liée au domaine du stockage d'énergie et plus particulièrement au domaine des batteries de type lithium-ion ou Li-ion.

Le développement d'indicateur de santé est devenu essentiel pour fournir une information fiable à l'utilisateur et cela que ce soient pour des applications embarquées ou stationnaires. L'état de santé (State Of Health - SOH) est une indication de l'usure d'une batterie. C'est la quantité totale d'énergie électrique stockable (Cp) rapportée à la capacité de stockage initiale (Cp initiale), c'est-à-dire la capacité de stockage effective (Cp) rapportée à la capacité de stockage initiale (Cp initiale).

Le paramètre SOH caractérise le vieillissement d'une batterie, c'est-à-dire son degré de dégradation au fur et à mesure de son utilisation en termes de capacité perdue (c'est-à-dire en perte d'autonomie) et en termes de performance (puissance développée). Les indicateurs d'état de santé peuvent être potentiellement très différents et basés sur des grandeurs électrochimiques (mesure de capacité, résistance électrique). Les indicateurs de type électrochimiques sont influencés par la température de fonctionnement de la batterie ce qui les rend donc complexes à mettre en oeuvre.

L'origine du vieillissement des batteries est liée à des mécanismes électrochimiques ou chimiques qui dégradent les composants internes. Les mécanismes internes responsables du vieillissement des batteries sont :

- la dégradation de l'électrolyte du fait de son domaine de stabilité électrochimique limité. Cette dégradation implique le dégagement de gaz par décomposition des molécules de solvants ;
- le vieillissement du film de passivation formé à la surface des particules s'il existe (c'est le cas des électrodes à base de graphite par exemple). Ce vieillissement correspond à des phénomènes mécaniques liés à des fracturations de couches passivantes et la production de gaz par formation d'une nouvelle couche de passivation lorsque l'électrode lithiée se retrouve en contact direct avec l'électrolyte. Ces événements produisent un stress mécanique à l'échelle des matériaux ;
- la dégradation des matériaux d'électrodes. Cela implique des micro-fractures à l'intérieur des structures cristallines, des changements de phase ou des pulvérisations de particules et la formation de gaz ;
- la corrosion des collecteurs de courant.

L'ensemble de ces mécanismes entraîne une perte irréversible des performances et une accumulation de contraintes ou de stress mécanique au sein de l'accumulateur.

Ces réactions de dégradation impliquent la production de gaz par décomposition de l'électrolyte ou corrosion du collecteur, par décomposition du film de passivation, ou des effondrements de structure cristalline ou la pulvérisation de particules.

Les indicateurs d'état de santé qui ont été développés jusqu'à présent ou qui sont en cours de développement sont basés essentiellement sur l'évolution des deux paramètres électriques courant et tension et des grandeurs qui leur sont liées :

- Comptage coulombique (ou ampère-heure métrique). C'est un indicateur précis à condition de disposer d'une fonction de recalibration et de pouvoir mesurer le courant de façon précise ;
- Mesure d'impédance et extraction de paramètres caractéristiques issus d'un modèle de circuit équivalent. C'est un indicateur précis mais qui est sensible à la température. Il est également difficile à mettre en oeuvre.

Il s'avère donc intéressant de pouvoir disposer d'un indicateur ne dépendant pas de la température et qui soit facile à mettre en oeuvre.

En considérant que les pertes de performances en cyclage (sous sollicitation en courant/tension) ou en calendaire (hors sollicitation) sont provoquées par des dégradations d'origine cristallines des matériaux actifs présents aux électrodes, par des décohésions de ces structures suite à des phénomènes d'expansion (contraction des particules), ou encore par des émissions de gaz qui génèrent des phénomènes acoustiques et que des capteurs spécifiques sont capables de les détecter, ces signaux acoustiques peuvent être reliés à l'état de santé de l'accumulateur et des nouveaux indicateurs d'état dans les systèmes de contrôle des batteries basés sur des paramètres acoustiques peuvent être envisagés.

On connaît du document EP2575205 un procédé de détection d'un changement d'état dans une batterie. Ce procédé repose sur une étape préalable de calibration à partir d'une batterie test, du même type que celle qui sera ensuite utilisée, pour déterminer une signature acoustique de la batterie test pour différents états internes de la batterie. La détermination de ces signatures nécessite des ressources de mémoire et de calcul très importantes. La détection d'un changement d'état dans une batterie en cours d'utilisation consiste à détecter une modification de la signature acoustique au cours du temps et à comparer la signature acoustique présente aux signatures de référence préalablement mémorisées. Là encore, ce procédé nécessite des moyens de calcul importants. Ces contraintes rendent le procédé inadapté à la détection de changement d'état en temps. Nina Kircheva ET AL: "Acoustic Methods as a Tool for Management of Electrochemical Process of Energy", 30th European Conference on Acoustic Emission Testing & 7th International Conference on Acoustic Emission, 12 septembre 2012, pages 1-10, décrit un procédé d'analyse d'une batterie utilisant un capteur d'activité acoustique. Le but de l'invention est de fournir un procédé de surveillance permettant de remédier aux problèmes évoqués précédemment et améliorant les procédés de surveillance connus de l'art antérieur. En particulier, l'invention propose un procédé de surveillance d'une batterie simple, fiable, non-intrusif et peu coûteux.

Selon l'invention, le procédé de détermination de l'état de santé d'une batterie utilise un capteur de l'activité acoustique de la batterie et comprend les étapes suivantes :

- détection, notamment détection en opération, d'au moins un évènement acoustique par le capteur au cours d'un cycle élémentaire d'utilisation de la batterie correspondant à une période d'utilisation de la batterie avec des opérations de charge et/ou de décharge ;
- détermination, notamment détermination en opération, de la valeur d'au moins un paramètre pour chaque signal acoustique détecté au cours du cycle élémentaire d'utilisation ;
- calcul, notamment calcul en opération, pour le cycle élémentaire d'utilisation, d'une valeur de densité acoustique selon une fonction de calcul de densité prenant en compte ledit au moins un paramètre déterminé pour chacun des signaux acoustiques détecté au cours du cycle, la fonction de calcul de densité étant une fonction monotone en fonction du nombre d'évènements détectés durant le cycle élémentaire ;
- calcul, notamment calcul en opération, d'une valeur d'état de santé correspondant à ladite valeur de densité acoustique précédemment calculée, à partir d'une relation fonctionnelle ou d'une base de données prédéfinie et permettant de connaître l'état de santé pour une valeur donnée de densité acoustique.

Selon l'invention, le procédé de caractérisation d'une batterie de test utilise un capteur de l'activité acoustique de la batterie de test et comprend plusieurs opérations de test successives réalisées lors de cycles élémentaires d'utilisation successifs de la batterie de test, chaque opération de test comprenant les étapes suivantes :

- détection, notamment détection en opération, d'au moins un évènement acoustique par le capteur au cours d'un cycle élémentaire d'utilisation de la batterie de test correspondant à une période d'utilisation de la batterie de test avec des opérations de charge et/ou de décharge ;
- détermination, notamment détermination en opération, de la valeur d'au moins un paramètre pour chaque signal acoustique détecté au cours du cycle élémentaire d'utilisation ;
- détermination, notamment détermination en opération, pour le cycle élémentaire d'utilisation, d'une valeur de densité acoustique selon une fonction de calcul de densité prenant en compte ledit au moins un paramètre déterminé pour chacun des signaux acoustiques détecté au cours du cycle, la fonction de calcul de densité étant une fonction monotone en fonction du nombre d'évènements détectés durant le cycle élémentaire ;
- détermination, notamment détermination en opération, au cours ou à la fin du cycle élémentaire de l'état de santé de la batterie de test ;
- mémorisation, notamment mémorisation en opération, dans une base de données, de l'état de santé et de la valeur de densité acoustique préalablement déterminées pour le cycle élémentaire considéré.

Le calcul d'une valeur d'état de santé correspondant à une valeur de densité acoustique peut est réalisé à partir d'une base de données prédéfinie selon le procédé de caractérisation défini précédemment.

Le procédé de caractérisation peut comprendre en outre une étape de détermination d'une relation fonctionnelle permettant de connaître l'état de santé de la batterie de test pour une valeur donnée de densité acoustique, à partir de ladite base de données.

Le calcul d'une valeur d'état de santé correspondant à une valeur de densité acoustique peut est réalisé à partir d'une base de données prédéfinie selon le procédé de caractérisation défini selon le paragraphe précédent.

Au moins un paramètre peut correspondre à la détection d'un évènement acoustique et la valeur de densité acoustique définie pour un cycle élémentaire peut correspondre au nombre d'évènements détectés durant le cycle.

Le procédé peut comprendre, à la suite de l'étape de détermination d'une valeur de densité acoustique pour le cycle élémentaire courant, une étape de calcul d'une valeur de densité acoustique lissée correspondant à une moyenne des N valeurs de densité acoustique les plus récentes et dans lequel la valeur de densité acoustique lissée peut être mémorisée dans la base de données et/ou utilisée pour le calcul de l'état de santé.

Au moins un paramètre d'un signal acoustique peut être pris parmi la liste suivante :

- amplitude du signal acoustique;
- énergie du signal acoustique;
- temps de montée du signal acoustique ;
- fréquence des oscillations du signal acoustique;
- durée du signal acoustique ;
- nombre de « coups » dans le signal acoustique, un coup correspondant à un dépassement d'un seuil ;
- fréquence des coups acoustiques, c'est-à-dire nombre de coups acoustiques par unité de temps dans le signal acoustique ;

- présence d'un événement acoustique.

La valeur de densité peut correspondre à une somme des valeurs dudit au moins un paramètre du signal acoustique.

Les dessins annexés représentent, à titre d'exemple, un mode de réalisation d'un dispositif de surveillance selon l'invention.

La figure 1 est un graphique illustrant l'évolution au cours du temps de l'intensité de l'activité acoustique pour un premier type de batterie.

La figure 2 est un graphique illustrant l'évolution au cours du temps de l'intensité de l'activité acoustique pour un deuxième type de batterie.

Les figures 3A et 3B sont des diagrammes illustrant un principe d'équivalence entre un fonctionnement avec des cycles de charge et décharge complets (3A) et un fonctionnement avec des cycles de charges et décharges partielles (3B).

La figure 4 est un graphique illustrant l'évolution de l'activité acoustique relevée par deux capteurs apposés sur une batterie, ainsi que l'évolution de la tension de la batterie sur plusieurs cycles dans une première plage temporelle correspondant à un début de vie de la batterie.

La figure 5 est un graphique illustrant l'évolution de l'activité acoustique relevée par deux capteurs apposés sur la batterie ainsi que l'évolution de la tension de la batterie sur plusieurs cycles dans une deuxième plage temporelle correspondant à une fin de vie de la batterie.

La figure 6 est un graphique illustrant l'évolution temporelle de l'état de santé d'une batterie et une moyenne glissante de la densité des phénomènes acoustiques dans une batterie sur la même période.

La figure 7 est un graphique illustrant des droites de régression linéaire permettant de modéliser une relation existant entre l'état de santé d'une batterie et une moyenne glissante de l'intensité d'un paramètre acoustique.

La figure 8 est un schéma d'un mode de réalisation d'un dispositif de surveillance selon un mode de réalisation de l'invention.

La figure 9 est un organigramme illustrant différents paramètres permettant de caractériser une émission acoustique.

La figure 10 est un ordinogramme d'un mode d'exécution d'un procédé de caractérisation selon l'invention.

La figure 11 est un ordinogramme d'un mode d'exécution d'un procédé de surveillance selon l'invention.

Comme indiqué précédemment, tous les phénomènes internes contribuant à la dégradation des performances de la batterie impliquent de façon générale l'émission d'ondes mécaniques lors des dégradations des composants et lors de la formation de gaz. Tous ces phénomènes conduisent à l'émission de signaux acoustiques détectables par des capteurs acoustiques dans des domaines particuliers de fréquences.

Une émission acoustique se définit comme étant un phénomène de création d'ondes élastiques transitoires, résultant de micro-déplacements locaux internes à un matériau. En d'autres termes, ce phénomène physique permet la détection et la localisation des endommagements évolutifs sous l'action d'une sollicitation mécanique quelconque. En complément de la localisation de défauts évolutifs, les émissions acoustiques fournissent donc des renseignements sur leurs cinétiques et sur leurs processus d'évolution. Le domaine de fréquence se situe typiquement entre 50kHz et 1,5 MHz.

L'invention concerne l'utilisation des signaux d'émission acoustique, émis par une cellule ou une batterie lorsqu'elle fonctionne, en particulier lorsqu'elle fonctionne dans une gamme de tensions autorisées. Ces signaux acoustiques sont utilisés et traités pour donner des informations sur l'état de santé. Suivant l'état de santé, la cellule ou la batterie peut être considérée comme non fonctionnelle pour son application voire dangereuse pour l'utilisateur ou l'environnement. Il est également possible de corriger d'autres paramètres de la batterie, tels que l'état de charge ou l'état d'énergie, connaissant l'état de santé.

Ainsi, l'invention s'appuie sur l'analyse de signaux acoustiques pour établir un indicateur d'état de santé de la batterie. Pour ce faire, un suivi en continu des événements acoustiques est réalisé tout au long de la vie de la batterie que ce soit en utilisation lors de phases de charge, de recharge ou au repos. L'activité acoustique enregistrée, peut permettre d'avoir des renseignements sur l'état de santé de la batterie comme expliqué ci-après. Cette évolution dépend de la technologie de batterie et donc des mécanismes de dégradation à l'échelle des matériaux. L'analyse des évolutions dépend de la technologie lithium utilisée.

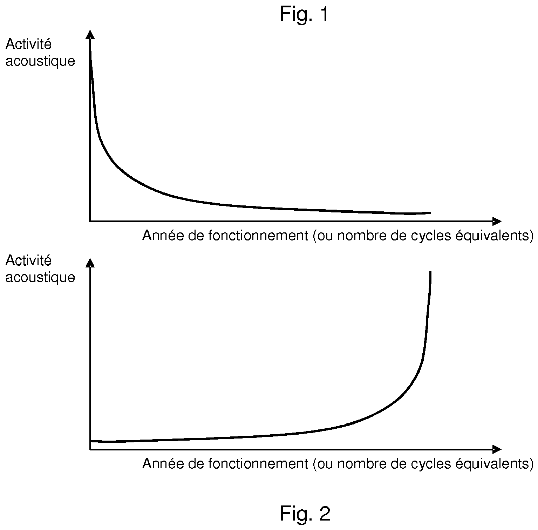

La figure 1 présente un exemple des évolutions qui peuvent être observées dans le cas d'une technologie lithium intégrant des matériaux pour lesquels l'incorporation du lithium se fait avec des modifications de la structure cristalline et de la composition chimique du matériau tels que par exemple les composés à réaction de conversion tels que $CoO$, $Co_3O_4$, $CuO$, $FeO$..., les alliages lithiés formés à partir de métal pur (Si, Sn, Al, Sb...) ou formés en deux étapes ($SnO$, $Cu_6Sn_5$). On voit que l'activité acoustique diminue rapidement lors des premières utilisations de la batterie puis décroit plus lentement ensuite.

La figure 2 présente un exemple des évolutions qui peuvent être observées dans le cas d'une technologie lithium intégrant des matériaux pour lesquels l'incorporation du lithium se fait sans changement majeur de la structure cristalline pour les intercalations dans une structure à deux dimensions tels que les composés de type graphite, oxyde lamellaire $LiMnO_2$ ou dans une structure à trois dimensions tels que les oxydes spinelle $LiMn_2O_4$ par exemple. On voit que l'activité acoustique augmente très lentement lors des premières utilisations de la batterie puis croit très rapidement lors des dernières utilisations.

Dans le cas de la figure 1 plus la cellule vieillie et donc perd de la capacité, moins l'activité acoustique est importante du fait qu'une part moins importante du matériau actif participe aux réactions électrochimiques. Cette perte de capacité et d'émission acoustique est liée par exemple à une pulvérisation des grains métalliques au moment de la formation du composé lithié : il y a perte de contact entre grains de matière active et le polymère liant qui enrobe le réseau de particules. Il y a formation de grains de plus en plus petits conduisant à une perte de contact électrique et à une diminution des bruits acoustiques.

Dans le cas de la figure 2, on est en présence de matériaux cristallisés de type intercalation ou insertion. Ces structures sont plus « silencieuses » en cyclage, dès lors que les cycles de formation et d'entraînement sont terminés. Pour ce type d'élément, les émissions acoustiques en vieillissement sont caractéristiques de la fracture du film de passivation et/ou de la dégradation des structures d'intercalation. L'activité acoustique augmente dans ce cas avec le temps.

Pour la mise en oeuvre d'un mode d'exécution du procédé de surveillance selon l'invention, on « découpe » les opérations de cyclage d'une batterie en une suite de cycles élémentaires. Chaque cycle élémentaire est défini en utilisant une valeur de référence d'une grandeur représentative du cyclage, c'est-à-dire des opérations de charge et décharge. A titre d'exemple, et comme décrit plus en détail ci-après, on peut considérer les grandeurs représentatives suivantes : une valeur de capacité en Ah, une valeur de variation d'état de charge SOC, une valeur d'énergie ou encore un temps d'utilisation en charge/décharge. On définit ainsi des instants de début et de fin de cycle élémentaire, en déterminant une variation positive et/ou négative de la grandeur représentative correspondant à la valeur de référence choisie.

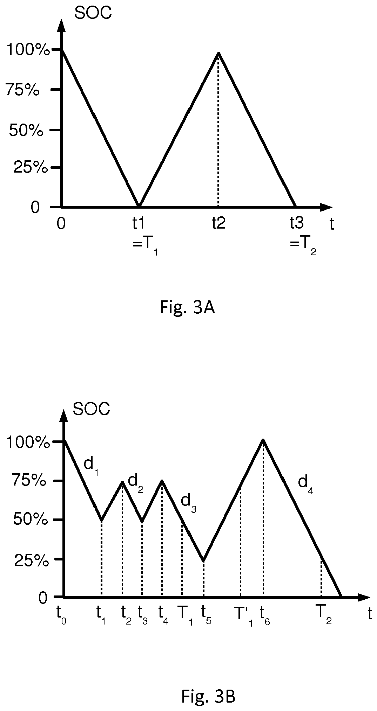

Ce procédé sera mieux compris au moyen des exemples illustratifs suivants, donnés en référence aux figures 3A et 3B qui représentent l'état de charge SOC en fonction du temps.

Le premier cas illustré en figure 3A est celui d'une succession de cycles complets de charge/décharge, tels que ceux réalisés en test dans un laboratoire. A l'instant initial t0, le SOC est égal à 100%, puis la batterie se décharge complètement jusqu'à un instant t1 où le SOC est égal à 0%, puis se recharge complètement jusqu'à un instant t2 où le SOC égal 100%, et ainsi de suite.

Le second cas illustré en figure 3B correspond à une utilisation de la batterie. On observe une succession de cycles d'amplitudes variées, avec des décharges et des recharges partielles ou complètes. Dans cet exemple, à l'instant initial t0, le SOC est égal à 100%, puis une décharge partielle d1 jusqu'à un instant t1 amène le SOC à 50%, une recharge jusqu'à un instant t2 amène le SOC à 75%, une décharge d2 jusqu'à un instant t3 amène le SOC à 50%, une recharge jusqu'à un instant t4 amène le SOC à 75%, une décharge d3 jusqu'à un instant t5 amène le SOC à 25%, une recharge partielle jusqu'à 100% amène le SOC à 100% et une décharge complète d4 amène le SOC à 0%.

Dans un premier exemple, on définit un cycle élémentaire en utilisant une valeur de capacité de référence Cref qui peut être prise égale à la capacité nominale de la batterie, c'est-à-dire au nombre d'ampère-heure pouvant être stockée dans la batterie dans des conditions nominales d'utilisation de la batterie en terme de courant d'utilisation et de température en début de vie de la batterie. On notera que la capacité nominale de la batterie correspond à la quantité d'ampère-heure restituée lors d'une décharge de la batterie entre 100% et 0% de SOC, ainsi qu'à la quantité d'ampère-heure emmagasinée lors d'une charge de la batterie entre 0% et 100%.

On considère alors qu'un cycle élémentaire a été réalisé quand l'intégrale du courant des opérations de décharge, c'est-à-dire la quantité d'ampères-heures restitués homogène à une valeur de capacité en Ah, est égale à cette valeur de capacité de référence.

Dans l'exemple le plus simple de la figure 3A, on considère donc un premier cycle élémentaire entre les instants t0 et t1, et un deuxième cycle élémentaire entre les instants t1 et t3.

D'un point de vue pratique, le procédé peut suivre une grandeur appelée « capacité en décharge Cdecharge», correspondant à l'intégrale du courant en décharge, entre un instant de réinitialisation correspondant au début d'un cycle élémentaire et l'instant présent et décider de l'instant de fin de cycle élémentaire quand la capacité en décharge est égale à la capacité de référence prédéfinie.

Dans l'exemple de la figure 3B, on considère ainsi que la capacité en décharge Cdecharge est incrémentée de Cref/2 entre t0 et t1, incrémentée de Cref/4 entre t2 et t3 puis incrémentée de Cref/2 jusqu'à un instant T1 située entre t4 et t5. Ainsi, à l'instant T1, la capacité en décharge Cdecharge est égal à Cref et T1 correspond à la fin du premier cycle élémentaire et au début du cycle élémentaire suivant. En appliquant le même calcul, la fin du deuxième cycle élémentaire correspond à un instant T2 pendant la décharge d4 au moment où le SOC est égal à 25%.

De façon similaire, on pourra définir un cycle élémentaire en considérant une grandeur appelée « capacité en charge Ccharge » correspondant à une intégrale du courant en charge, entre un instant de réinitialisation correspondant au début d'un cycle élémentaire et l'instant présent.

On pourra également considérer une combinaison des capacités en charge Ccharge et décharge Cdécharge (par exemple appelée Cmoyen), pour définir les instants de début et fin d'un cycle élémentaire, en considérant par exemple qu'un cycle élémentaire est terminé quand les capacités en charge Ccharge et en décharge Cdecharge ont toutes les deux atteint la capacité de référence prédéfinie.

Comme l'homme de l'art l'aura compris, en début de vie, les grandeurs suivies Ccharge, Cdecharge, Cmoyen sont nulles et celles-ci sont réinitialisées chaque fois qu'un cycle élémentaire est terminé.

Eventuellement, la valeur de capacité de référence peut elle-même être corrigée par un état de santé mesuré au cours du temps. La détermination des cycles élémentaires tient ainsi compte de l'évolution de la capacité effective de la batterie.

Dans un deuxième exemple, on définit un cycle élémentaire en utilisant une valeur de variation d'état de charge SOC de référence par exemple égale à 100%. On considère ensuite qu'un cycle élémentaire a été réalisé quand la variation négative de SOC est égale à 100%, comme c'est le cas par exemple entre les instants t0 et t1, et entre t1 et t3 en figure 3A ou entre les instants t0 et T1 et entre les instants T1 et T2 en figure 3B. De façon similaire, on peut considérer qu'un cycle élémentaire est réalisé quand la variation positive de SOC est égale à 100%, comme c'est le cas par exemple entre les instants t0 et t2 en figure 3A, où entre les instants t0 et T'1 de la figure 3B, avec T'1 correspondant à un instant situé entre t5 et t6 pour lequel le SOC égal 75%. Comme précédemment pour la capacité, on peut dans le cas d'une variation de SOC considérer qu'un cycle élémentaire se termine quand la variation positive et la variation négative de SOC ont toutes deux atteintes la valeur de référence de 100% dans cet exemple.

Selon un troisième exemple, on considère qu'un cycle élémentaire est défini par une durée d'utilisation, c'est-à-dire un temps cumulé de phases actives de charge et décharge, sans considérer d'éventuelles phases de repos intermédiaires. Ceci revient sensiblement au même qu'un calcul de capacité en charge et décharge si le courant de charge/décharge est constant.

Dans les exemples précédents, un cycle élémentaire est défini sur une variation d'une grandeur pendant l'équivalent d'un cycle complet de charge/décharge, mais on pourrait considérer une amplitude de variation de cette grandeur physique correspondant à une fraction d'un cycle complet ou correspondant à plusieurs cycles complets de charge/décharge. En outre, bien que les exemples décrits en relation avec la figure 3A et 3B concernent des charges et décharges en continu, les différentes phases de charge et décharge peuvent être entrecoupées (espacées) de phases de repos.

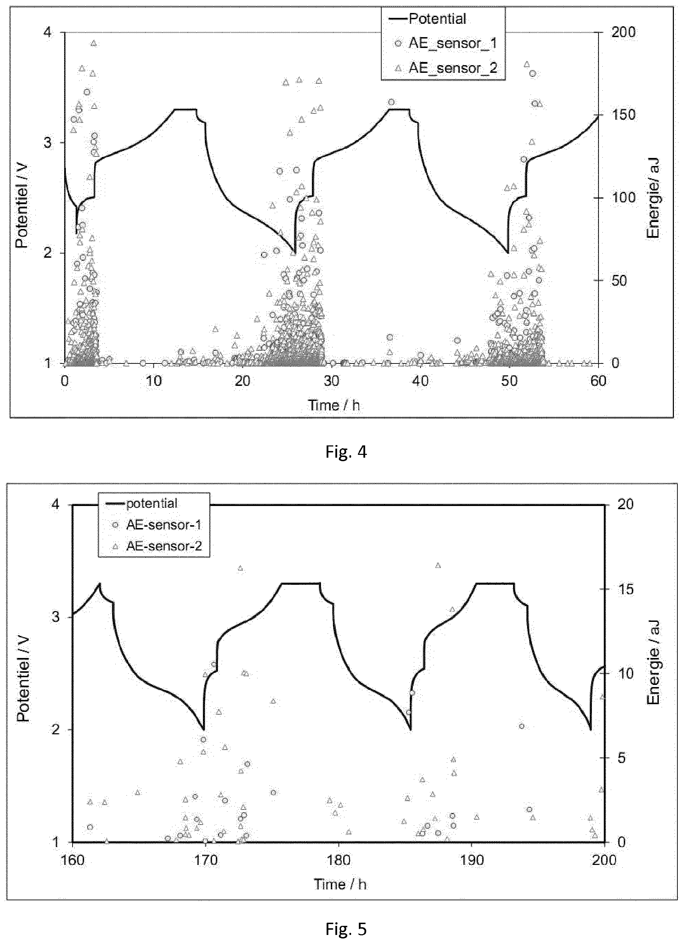

Un exemple de batterie pouvant être surveillée par mise en oeuvre du procédé objet de l'invention est une batterie LiAl/LiMnO$_2$, constitué d'un alliage intermétallique Lithium-Aluminium (LiAl) pour l'électrode négative et un matériau d'intercalation, le dioxyde de manganèse lithié (LiMnO$_2$) pour l'électrode positive. Les réactions mises en jeu sont représentées à la figure 5 au niveau de chaque électrode. La réaction bilan est aussi représentée dans le cas général et dans le cas ou x=1.

Les figures 4 et 5 sont des graphiques représentant l'activité acoustique qui a été enregistrée en continu lors d'un cyclage d'une batterie réalisé à un régime C/20, c'est-à-dire avec un courant de charge permettant de charger complètement la batterie en 20 heures. Un capteur AE-sensor-1 était placé au niveau du pôle positif de la batterie. Un capteur AE-sensor-2 était placé au niveau du pôle négatif de la batterie. Les phases de charge et décharge sont séparées par des phases de relaxation à courant nul. On remarque que l'activité acoustique varie avec la tension de la batterie et qu'elle est relativement importante dans les phases de relaxation après décharge (avant de recommencer une nouvelle charge). On remarque là encore une baisse de l'intensité d'un paramètre d'émission acoustique au fil du temps (en comparant les figures 4 et 5).

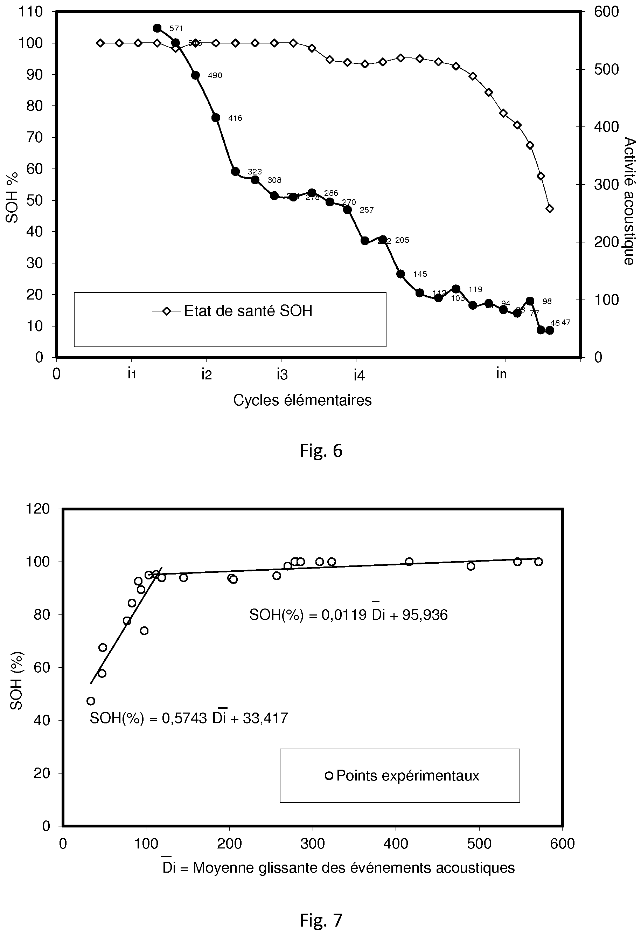

Différents tests sur des batteries du même type permettent d'élaborer des graphiques tels que ceux représentés en figure 6 et 7. Le graphique 6 représente les évolutions de l'état de santé et de l'activité acoustique en fonction du nombre de cycles élémentaires réalisés. L'état de santé est exprimé en pourcentage par rapport à une valeur de capacité de référence. L'activité acoustique représentée correspond à une moyenne glissante $\overline{D}_i$ d'un paramètre D représentant une densité d'événements acoustiques (hits) dans le cas de cycles complets de charge et décharge. Dans l'exemple illustré, l'état de santé diminue avec l'activité acoustique.

Le graphique de la figure 7, représente l'état de santé SOH en fonction d'une densité lissée $\overline{D}_i$ correspondant dans l'exemple illustré à une moyenne glissante d'un nombre d'évènements acoustiques détectés par cycle élémentaire. On constate qu'on peut déterminer une relation existant entre l'activité acoustique, représentée par $\overline{D}_i$, et l'état de santé par des lois de régression linéaire. Comme cela est visible sur la figure 7, une première relation linéaire de faible pente peut être utilisée pour modéliser la relation entre un SOH élevé (début de vie de la batterie) et une densité lissée $\overline{D}_i$ d'évènements supérieure à 100 évènements acoustiques détectés par cycle élémentaire. Une seconde relation linéaire de plus forte pente peut être utilisée pour modéliser la relation entre un SOH se dégradant, en dessous de 98% jusqu'à 50%, et une densité lissée $\overline{D}_i$ d'évènements plus faible, inférieure à 100.

On notera, que si D est la densité d'évènements acoustiques par cycle élémentaire, sa moyenne glissante au cycle élémentaire i, $\overline{D}_i$, est donnée par la formule suivante :

$$\overline{D}_i = \frac{1}{N}\sum_{k=0}^{N-1} D_{i-k}$$

où N représente le nombre de cycle élémentaires sur lequel est calculée la moyenne.

Dans l'exemple illustré en figure 7, une relation mathématique f permet de lier le SOH et la densité $\overline{D}_i$ SOH=f($\overline{D}_i$), cette relation pouvant par exemple être formulée au moyen des équations ou des paramètres définissant les deux relations linéaires susmentionnées. Les données permettant de matérialiser cette relation f sont stockées dans une mémoire pour une utilisation future, afin d'être utilisée pour déterminer l'état de santé d'une batterie en cours d'utilisation.

Lors de l'utilisation d'une batterie du type de celles utilisées en phase de test pour obtenir la relation SOH=f($\overline{D}_i$) susmentionnée, il est possible de mettre en oeuvre un procédé utilisant ces données pour calculer ou déterminer l'état de santé SOH de la batterie à partir de valeurs courantes du paramètre D obtenu par détection d'évènements acoustiques, en utilisant de préférence une moyenne glissante $\overline{D}_i$ dans le cas où la relation obtenue après test a été obtenue en prenant en compte des valeurs de densité filtrée, autrement dit moyennée, $\overline{D}_i$. Ainsi, un utilisateur peut connaître de manière fiable l'état de santé d'une batterie sur la base d'une détection d'évènements acoustiques.

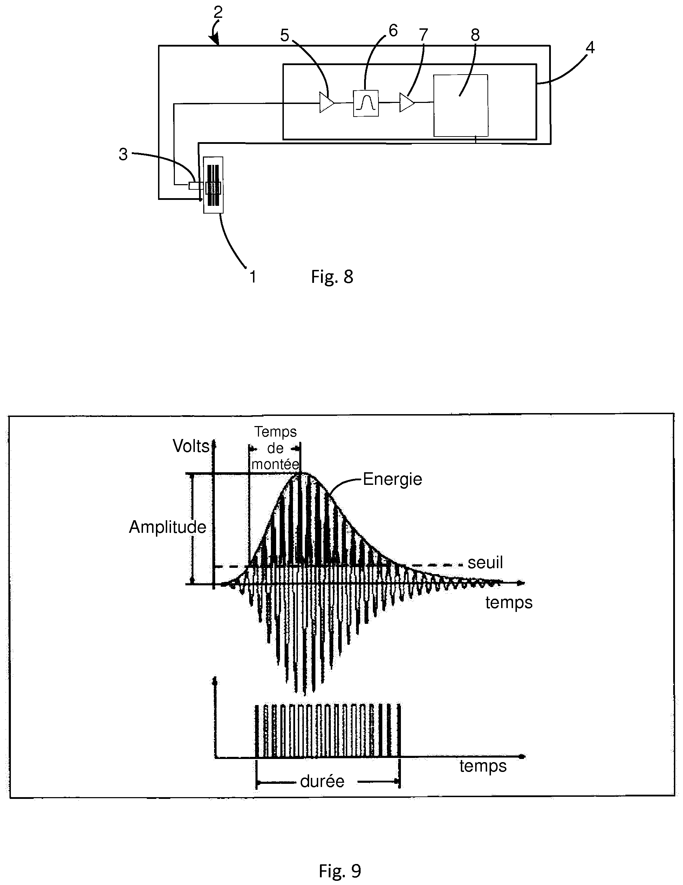

Un mode de réalisation d'un dispositif 2 de surveillance d'une batterie 1, comprenant une ou plusieurs cellules électrochimiques, est décrit ci-après en référence à la figure 8. Le dispositif de surveillance repose sur la détection et l'analyse des émissions acoustiques produites dans la batterie. À cette fin, le dispositif de surveillance comprend principalement un dispositif 3 d'acquisition de données relatives à des émissions acoustiques produites dans la batterie et un dispositif de traitement 4 permettant de déterminer l'état de santé de la batterie.

Le dispositif d'acquisition de données peut comprendre un ou plusieurs capteurs d'ondes acoustiques 3a, 3b placées par exemple au contact d'une cellule électrochimique ou sur le boitier de la batterie si on ne souhaite pas « dédier » un capteur à une cellule électrochimique.

Le dispositif d'acquisition 3 est destiné à détecter les émissions acoustiques produites au sein de la batterie 1 et de les convertir en un signal, notamment en un signal électrique. À cette fin, le dispositif d'acquisition est disposé de préférence au plus proche du lieu de production des émissions acoustiques. En particulier, il est intéressant de disposer le dispositif d'acquisition au niveau d'une paroi de la cellule ou de la batterie, par exemple sur une face de la cellule ou de la batterie. Ainsi, les émissions acoustiques peuvent arriver au niveau du dispositif d'acquisition en traversant uniquement des composants de la cellule ou de la batterie. Le dispositif d'acquisition peut donc être fixé sur une cellule ou sur la batterie. Un premier élément de capteur peut être disposé sur une borne positive. Un deuxième élément de capteur peut être disposé sur une borne négative. Le dispositif d'acquisition peut être du type acoustique ou d'un autre type, comme un accéléromètre, l'important étant qu'il puisse détecter les émissions acoustiques produites dans la cellule ou la batterie et les transformer en un signal qui puisse être analysé. Le dispositif d'acquisition peut être du type piezoélectrique. Notamment, le dispositif d'acquisition permet de détecter et transformer des émissions acoustiques dont la fréquence est comprise entre 1 kHz et 3 MHz, en particulier entre 50 kHz et 1,5 MHz.

Le dispositif d'acquisition comprend en outre dans cet exemple un dispositif 3c d'élimination de données aberrantes qui peut par exemple se baser sur les éventuelles multiples détections dans le cas où plusieurs capteurs sont utilisés.

Le signal obtenu en sortie du dispositif d'acquisition est fonction du phénomène générant les émissions acoustiques, de la transmission des émissions acoustiques dans la cellule ou dans la batterie jusqu'au dispositif d'acquisition et fonction de la transformation par le dispositif d'acquisition du signal reçu par le ou les capteurs en un signal de sortie.

Le signal de sortie du dispositif d'acquisition est ensuite envoyé au dispositif de traitement du signal 4. Par exemple, ce dispositif de traitement du signal comprend un préamplificateur 5, un filtre, un amplificateur 7 et éventuellement un élément de mise en forme des signaux électriques non représenté.

Ce dispositif de traitement 4 permet de caractériser les émissions acoustiques détectées dans la batterie en analysant chaque signal acoustique reçu au moyen d'un dispositif d'analyse 8. Le dispositif d'analyse permet de déterminer un ou plusieurs paramètres du signal acoustique, tels que définis ci-après, et permet sur la base des valeurs de ces paramètres d'obtenir une valeur d'état de santé de la batterie en mettant en oeuvre le procédé de la présente invention. Cette valeur d'état de santé SOH peut ensuite être utilisée par tout autre système. Notamment, la valeur d'état de santé peut être transmise à une interface homme-machine permettant d'informer un utilisateur de l'état de santé de la batterie.

Le dispositif de surveillance comprend tous les éléments matériels et/ou logiciels permettant de mettre en oeuvre le procédé de surveillance objet de l'invention.

Une partie du dispositif d'acquisition peut comprendre des moyens logiciels. De même, tout ou partie du dispositif de traitement peut comprendre des moyens logiciels.

Différents modes d'exécution d'un procédé de détermination de l'état de santé d'une batterie selon l'invention sont décrits ci-après. Dans un procédé de caractérisation pouvant être réalisé en usine, on élabore, pour un type particulier de batterie, une relation entre l'état de santé de la batterie et un paramètre reflétant la densité d'évènements acoustiques dans la batterie. Cette relation peut ensuite être utilisée pour déterminer l'état de santé d'une batterie au cours de sa vie, au fur et à mesure de son utilisation.

Le procédé de calibration, et par suite, le procédé de détermination de l'état de santé d'une batterie utilisant la relation définie lors du procédé de caractérisation, utilisent tous deux des notions et des opérations similaires. Les deux procédés « découpent » les cycles ou le temps de charge/décharge, en cycle élémentaire comme décrit précédemment. Pour chaque cycle élémentaire, on détecte les signaux acoustiques émis par la batterie et on détermine pour chaque signal acoustique, un ou plusieurs paramètres caractéristiques du signal acoustique. On détermine ensuite pour chaque cycle élémentaire une valeur de densité D à partir des valeurs prises par le ou les paramètres caractéristiques relevés pour chaque signal acoustique mesuré durant le cycle élémentaire.

La figure 9 représente un signal acoustique relevé pour un événement acoustique de la batterie. Les paramètres caractéristiques du signal acoustique peuvent correspondre à un ou plusieurs des paramètres suivants :

- amplitude du signal acoustique;
- énergie du signal acoustique;
- temps de montée du signal acoustique ;
- fréquence des oscillations du signal acoustique;
- durée du signal acoustique ;
- nombre de « coups » dans le signal acoustique, un coup correspondant à un dépassement d'un seuil ;
- fréquence des coups acoustiques, c'est-à-dire nombre de coups acoustiques par unité de temps dans le signal acoustique ;
- présence d'un événement acoustique par détection par exemple d'au moins un coup, et éventuellement d'une amplitude et/d'une durée minimale du signal acoustique (notion binaire : présence = 1 pendant l'apparition d'un signal acoustique).

Il est à noter que la fréquence des pics, des coups ou des oscillations à l'intérieur d'un signal acoustique correspondant à un unique évènement acoustique est à différencier d'une fréquence de survenue des émissions acoustiques au cours du temps.

A partir d'un paramètre caractéristique ou d'une combinaison de paramètres caractéristiques relevés pour chaque signal acoustique lors d'un cycle élémentaire, on calcule une valeur de densité D représentative de la densité d'évènements acoustiques relevés au cours du cycle élémentaire. A titre d'exemple le plus simple, la densité D peut être égale au nombre de fois où le paramètre « présence » est actif pendant le cycle élémentaire. La densité D peut être égale à la somme des amplitudes de chacun des évènements détectés, ou être égale à la somme des produits Amplitude×durée calculés pour chacun des évènements, et ainsi de suite. La densité D serait ainsi définie comme suit $D = \sum_{j=0}^{nE} Pj$ ; avec $Pj$ correspondant à la valeur d'un paramètre ou une combinaison de valeurs de paramètres relevés pour un j-ième signal acoustique du cycle élémentaire et nE correspondant au nombre d'évènement du cycle élémentaire considéré.

La densité D peut être une somme comme dans le cas ci-dessus, mais on pourrait utiliser une autre fonction qui prenne en compte la ou les valeurs de paramètres de chacun des signaux acoustiques du cycle élémentaire. Néanmoins, dans la présente invention, il est nécessaire que la fonction de calcul de D soit une fonction monotone, croissante ou décroissante, en fonction du nombre d'évènements détectés dans un cycle élémentaire.

En outre, on utilisera de préférence une valeur de densité D filtrée (passe-bas), ou lissée, notée $\overline{D_i}$, pour le cycle élémentaire courant noté i. Une telle densité lissée, notée $\overline{D_i}$, peut avantageusement correspondre à une moyenne glissante sur plusieurs cycles élémentaires, au nombre de N, telle que $\overline{D_i} = \frac{1}{N} \sum_{k=0}^{N-1} D_{i-k}$ .

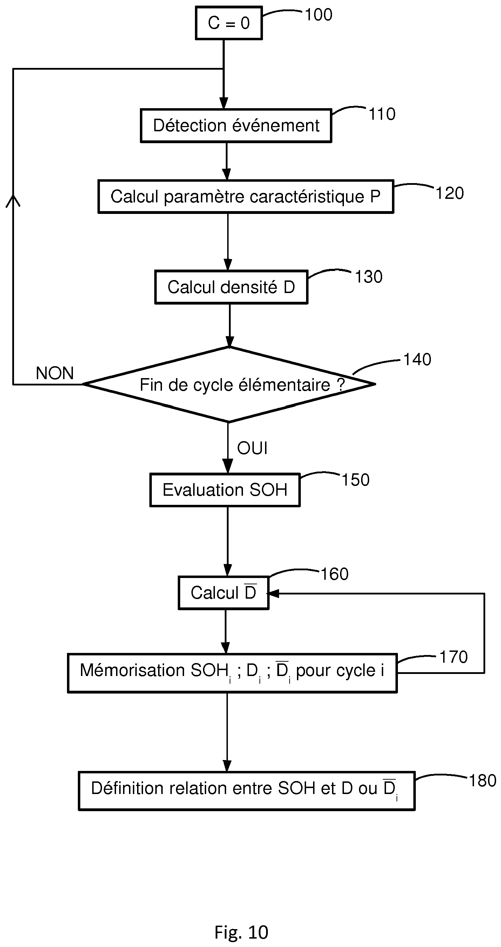

Un exemple de procédé de caractérisation est décrit ci-après en relation avec la figure 10. Ce procédé de caractérisation est réalisé à partir de batteries de test neuves, qui vont être chargées puis déchargées en boucle jusqu'à ce que les batteries de test soient jugées mortes ou en fin de vie selon un critère de SOH minimum prédéfini, par exemple une valeur d'état de santé SOH de 60%. Au cours de ces cycles de charge/décharges, on évalue l'état de santé au moyen d'un dispositif d'évaluation autre que celui de la présente invention. On pourra par exemple intégrer les ampères-heures en charge et décharge pour obtenir une valeur de capacité présente de la batterie de test et la comparer à la capacité initiale pour obtenir une valeur d'état de santé. En outre, durant ces cycles de la batterie de test, on découpe le temps ou les cycles en cycle élémentaire en suivant un indicateur de cycle C qui est remis par exemple remis à 0 à chaque nouveau cycle et égal à une valeur de référence à la fin de chaque cycle élémentaire.

Le procédé est décrit plus en détails ci-après à l'aide de l'organigramme de la figure 10.

Dans une étape initiale 100, on initialise l'indicateur de cycle C.

Dans une étape 110, on détecte un évènement acoustique.

Dans une étape 120, on calcule/détermine un ou plusieurs paramètres caractéristiques P1 à Pm du signal acoustique, m nombre entier, et on calcule une éventuelle combinaison de paramètre P à partir des paramètres caractéristiques P1 à Pm.

Dans une étape 130, on calcule une valeur de densité D égale à une fonction F des paramètres P relevés pour chacun des évènements relevés pour le cycle élémentaire en cours. Si la densité D est égale à une somme d'un paramètre, par exemple l'amplitude, relevé pour chaque évènement, on incrémente la valeur D à chaque survenue d'un nouveau signal dans le cycle élémentaire en cours.

Dans une étape 140, on regarde si le cycle élémentaire en cours est terminé ou non. Dans la négative, on continue la détection des évènements par reprise éventuelle des étapes 110, 120 puis 130. Dans l'affirmative, on réinitialise l'indicateur de cycle C par retour à l'étape 100.

Dans une étape 150, à laquelle on passe si la réponse est positive à l'étape précédente (cycle terminé), on évalue une valeur d'état de santé SOH au moyen du dispositif d'évaluation associé susmentionné.

Dans une étape 160, éventuellement facultative, on calcule une valeur de densité lissée $\overline{D}_i$ pour le cycle élémentaire i qui s'est terminé, sur la base des valeurs éventuellement connues (après plusieurs cycles) de densité Di obtenues lors des cycles précédents.

Dans une étape 170, on mémorise les informations d'état de santé SOHi, la valeur de densité Di relevé et la valeur de densité lissée $\overline{D}_i$ correspondant au cycle élémentaire i.

Dans une étape 180, réalisée en fin de vie de la batterie test, on définit une relation fonctionnelle entre l'état de santé SOH et les valeurs de densité Di ou de préférence les valeurs de densité $\overline{D}_i$.

Le procédé de caractérisation est alors terminé.

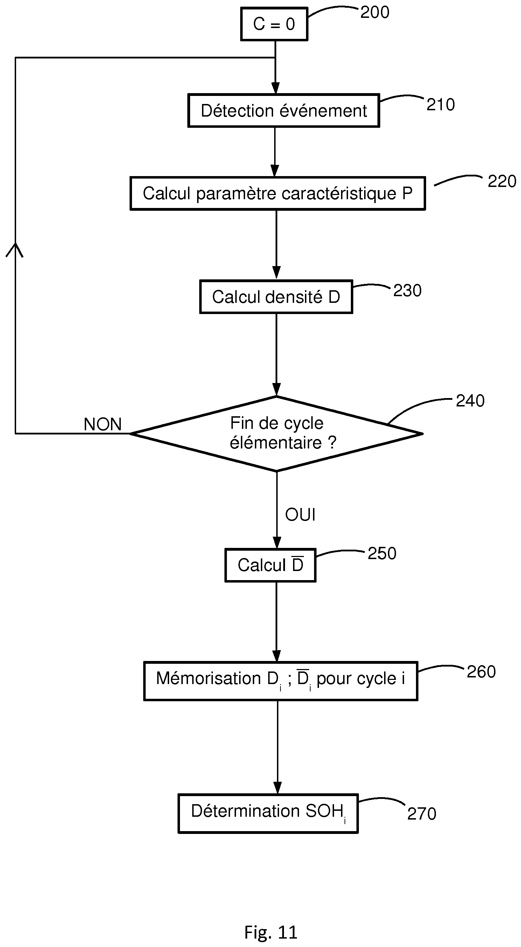

Lors de l'utilisation d'une batterie, du même type que la batterie de test, il est alors possible d'utiliser la relation fonctionnelle obtenue selon le procédé de caractérisation précédent, pour déterminer au fur et à mesure de l'utilisation de la batterie, une valeur d'état de santé. Un exemple de procédé permettant une telle détermination est illustré en figure 11.

Au cours de l'utilisation de la batterie, on effectue, au cours des étapes 200 à 240, un suivi des émissions acoustiques et des calculs selon le même procédé que celui mis respectivement en oeuvre lors des étapes 100 à 140 précédemment décrites.

A la fin de chaque cycle élémentaire, c'est-à-dire lorsque la réponse à l'étape 240 est positive, on calcule, lors d'une étape 250, une valeur de densité lissée $\overline{D}_i$ pour le cycle élémentaire i qui s'est terminé, sur la base des valeurs éventuellement connues (après plusieurs cycles) de densité Di obtenues lors des cycles précédents ou sur la base des valeurs de densité lissées $\overline{D}_{i-k}$ précédemment obtenues.

Lors d'une étape 260, on mémorise les valeurs Di et/ou $\overline{D}_i$ précédemment calculées pour le cycle i.

Lors d'une étape 270, on détermine une valeur d'état de santé courant SOHi pour le cycle i, sur la base des valeurs Di ou $\overline{D}_i$ précédemment calculés et de la relation fonctionnelle prédéfinie entre l'état de santé SOH et les valeurs de densité Di ou les valeurs de densité lissées $\overline{D}_i$.

Selon un mode de mise en oeuvre du procédé de caractérisation et par suite du procédé de détermination de SOH, on mémorise uniquement les informations d'état de santé SOHi, de densité Di ou $\overline{D}_i$, pour chaque cycle (voir étape 170) dans une base de données et on utilise ensuite cette base de données à l'étape 270 du procédé de détermination pour retrouver l'état de santé présent de la batterie. Pour ce faire, il est possible d'utiliser des algorithmes d'optimisation utilisant la base de données et la valeur de densité pour calculer un état de santé.

Selon un autre mode de mise du procédé de caractérisation et par suite du procédé de détermination de SOH, on détermine, comme dans l'étape 180, une relation fonctionnelle entre l'état de santé et la densité Di ou $\overline{D}_i$. Cette relation est par exemple stockée dans un calculateur du dispositif de traitement 8. Par exemple, la relation fonctionnelle mathématique comprend une relation affine liant les valeurs de densité à des valeurs d'état de santé, ou comprend plusieurs relations affines valables sur des intervalles distincts de densité. Une relation affine est particulièrement simple à mémoriser et utiliser par la suite : elle peut être stockée dans une mémoire via l'enregistrement de deux seules valeurs, à savoir un coefficient directeur et une ordonnée à l'origine. De même, il est particulièrement simple et peu consommateur de ressource d'utiliser une telle relation mathématique pour calculer l'état de santé connaissant la densité Di ou $\overline{D}_i$.

Dans le cas où la batterie utilisée réalise des cycles de charge/décharge non complets, ce qui est fréquent, on pourra prévoir d'adapter le procédé de détermination de l'état de santé pour tenir compte du type de cycles réalisés. En effet, en regardant la figure 4, on constate que le nombre d'évènements n'est pas uniforme sur toutes la plage d'état de charge, SOC. Dans l'exemple illustré, quand la charge est élevée, SOC supérieur à 80%, le nombre d'évènements acoustiques est relativement faible. Inversement, quand la charge est faible, SOC inférieur à 40%, le nombre d'évènements acoustiques est relativement élevé. La relation fonctionnelle entre l'état de santé et la densité acoustique D étant obtenue pour un type de cyclage donné, par exemple complet, l'utilisation d'une telle relation fonctionnelle peut conduire à une détermination erronée de l'état de santé si le niveau d'état de charge de la batterie est par exemple toujours supérieur à 50%. Afin de tenir compte des caractéristiques de cyclage réelles, on pourra analyser le SOC (ou un autre paramètre donnant une information similaire, telle que la tension par exemple) lors des cycles élémentaires réalisés et réaliser une détermination de l'état de santé prenant compte les valeurs de SOC relevées.

Une correction envisageable consiste à réaliser différentes natures de cyclage lors des phases de caractérisation, en prévoyant par exemple un cyclage « haut » entre 50% et 100% de SOC et un cyclage « bas » entre 0% et 50% de SOC. On obtient ainsi deux bases de données et par suite deux relations fonctionnelles utilisables ensuite en fonction de la nature des cycles réalisés par la batterie.

De façon alternative, ou complémentaire, on pourra prévoir d'appliquer le procédé de détermination du SOH uniquement dans certaines conditions d'utilisation de la batterie. Par exemple, on pourra prévoir de ne pas faire d'estimation de SOH si le SOC lors du cycle courant a été majoritairement supérieur à 80%, ou majoritairement inférieur à 20% ou tout autre seuil/critère que l'on jugera acceptable en fonction du type de batterie.

Les relations mathématiques utilisées pour retrouver l'état de santé connaissant la densité acoustique $D_i$ ou $\overline{D}_i$ comprennent avantageusement une ou plusieurs relations affines valables sur des intervalles distincts de densité acoustique.

Ainsi, autrement formulé, selon l'invention, le procédé de détermination de l'état de santé d'une batterie comprend une première phase de détection et/ou d'acquisition de données en opération, suivie par une deuxième phase de détermination et/ou d'analyse et/ou de traitement des données, notamment en opération, puis une troisième phase de détermination de l'état de santé basée sur l'utilisation des résultats de la deuxième phase.

De préférence, dans le procédé selon l'invention, dans la première phase, on détecte et/ou on acquiert des données en opération, notamment on détecte au moins un évènement acoustique par le capteur au cours d'un cycle élémentaire d'utilisation de la batterie correspondant à une période d'utilisation de la batterie avec des opérations de charge et/ou de décharge. Ainsi, de préférence, on détecte au moins un évènement acoustique par le capteur, en opération, au cours d'un cycle élémentaire d'utilisation de la batterie correspondant à une période d'utilisation de la batterie avec des opérations de charge et/ou de décharge.

De préférence, dans le procédé selon l'invention, dans la deuxième phase, on détermine une valeur de paramètre et/ou on analyse et/ou on traite des données, notamment en opération. Cette deuxième phase est réalisée en opération. Notamment, dans cette deuxième phase, on détermine la valeur d'au moins un paramètre pour chaque signal acoustique détecté au cours du cycle élémentaire d'utilisation et on calcule, pour le cycle élémentaire d'utilisation, une valeur de densité acoustique selon une fonction de calcul de densité prenant en compte ledit au moins un paramètre déterminé pour chacun des signaux acoustiques détecté au cours du cycle, la fonction de calcul de densité étant une fonction monotone en fonction du nombre d'évènements détectés durant le cycle élémentaire.

De préférence, dans le procédé selon l'invention, dans la troisième phase, on détermine l'état de santé en se basant sur l'utilisation des résultats de la deuxième phase. Notamment, on calcule une valeur d'état de santé correspondant à ladite valeur de densité acoustique précédemment calculée, à partir d'une relation fonctionnelle ou d'une base de données prédéfinie et permettant de connaître l'état de santé pour une valeur donnée de densité acoustique.

Dans tout le présent document, par les termes « en opération », on entend « en fonctionnement » ou « en continu » ou « alors que la batterie fonctionne, c'est-à-dire alors que la batterie assure sa fonction en alimentant une charge ou en étant rechargée par une source d'énergie électrique ». Avantageusement, les termes « en opération » excluent des phases exclusives de test dans lesquelles une batterie est déconnectée de la charge qu'elle alimente habituellement et/ou est déconnectée de la source d'énergie électrique par laquelle elle est habituellement rechargée. Ainsi, par ces termes, on exclut des phases de diagnostic pur et/ou ponctuel dans lesquelles la batterie est isolée pour subir des tests.

Dans le cas de phases de diagnostic pur et/ou ponctuel, une batterie ne fournit plus son service ou n'assure plus ses fonctions. Elle est sollicitée suivant un profil tension/courant particulier (appelé « check-up »), ce profil étant très différent d'un profil typique de fonctionnement d'une batterie.

Ainsi, grâce au procédé selon l'invention, la batterie peut, à chaque instant ou en continu, assurer les fonctions pour lesquelles elle est prévue, notamment les fonctions essentielles d'alimentation d'une charge et de recharge à partir d'une source d'énergie électrique. Il y a ainsi continuité du service ou des fonctions de la batterie. La détermination de l'état de santé de la batterie se fait au cours de son fonctionnement ou de son utilisation.

## Revendications

1. Procédé de détermination de l'état de santé d'une batterie (1), utilisant un capteur (3) de l'activité acoustique de la batterie, comprenant les étapes suivantes :

    - détection d'au moins un évènement acoustique par le capteur au cours d'un cycle élémentaire d'utilisation de la batterie correspondant à une période d'utilisation de la batterie avec des opérations de charge et/ou de décharge ;
    - détermination de la valeur d'au moins un paramètre (P) pour chaque signal acoustique détecté au cours du cycle élémentaire d'utilisation ;
    - calcul, pour le cycle élémentaire d'utilisation, d'une valeur de densité acoustique (D ou $\overline{D}_i$) selon une fonction de calcul de densité prenant en compte ledit au moins un paramètre (P) déterminé pour chacun des signaux acoustiques détecté au cours du cycle, la fonction de calcul de densité étant une fonction monotone en fonction du nombre d'évènements détectés durant le cycle élémentaire ;

- calcul d'une valeur d'état de santé correspondant à ladite valeur de densité acoustique précédemment calculée, à partir d'une relation fonctionnelle ou d'une base de données prédéfinie et permettant de connaître l'état de santé pour une valeur donnée de densité acoustique.

2.  Procédé de caractérisation d'une batterie de test, utilisant un capteur de l'activité acoustique de la batterie de test, comprenant plusieurs opérations de test successives réalisées lors de cycles élémentaires d'utilisation successifs de la batterie de test, chaque opération de test comprenant les étapes suivantes :

    - détection d'au moins un évènement acoustique par le capteur au cours d'un cycle élémentaire d'utilisation de la batterie de test correspondant à une période d'utilisation de la batterie de test avec des opérations de charge et/ou de décharge ;
    - détermination de la valeur d'au moins un paramètre (P) pour chaque signal acoustique détecté au cours du cycle élémentaire d'utilisation ;
    - détermination, pour le cycle élémentaire d'utilisation, d'une valeur de densité acoustique (Di ou $\overline{D}_i$) selon une fonction de calcul de densité prenant en compte ledit au moins un paramètre (P) déterminé pour chacun des signaux acoustiques détecté au cours du cycle, la fonction de calcul de densité étant une fonction monotone en fonction du nombre d'évènements détectés durant le cycle élémentaire ;
    - détermination au cours ou à la fin du cycle élémentaire de l'état de santé de la batterie de test ;
    - mémorisation dans une base de données, de l'état de santé (SOH) et de la valeur de densité acoustique (Di ou $\overline{D}_i$) préalablement déterminées pour le cycle élémentaire considéré.

3.  Procédé de caractérisation d'une batterie de test selon la revendication 2, comprenant en outre une étape de détermination d'une relation fonctionnelle permettant de connaître l'état de santé de la batterie de test pour une valeur donnée de densité acoustique, à partir de ladite base de données.

4.  Procédé de détermination de l'état de santé d'une batterie selon la revendication 1, dans lequel le calcul d'une valeur d'état de santé correspondant à une valeur de densité acoustique est réalisé à partir d'une base de données prédéfinie selon le procédé de caractérisation de la revendication 2.

5.  Procédé de détermination de l'état de santé d'une batterie selon la revendication 1, dans lequel le calcul d'une valeur d'état de santé correspondant à une valeur de densité acoustique est réalisé à partir d'une relation fonctionnelle préalablement définie selon le procédé de caractérisation de la revendication 3.

6.  Procédé selon l'une des revendications précédentes, dans lequel ledit au moins un paramètre correspond à la détection d'un évènement acoustique et la valeur de densité acoustique (Di) définie pour un cycle élémentaire correspond au nombre d'évènements détectés durant le cycle.

7.  Procédé selon l'une des revendications précédentes, comprenant, à la suite de l'étape de détermination d'une valeur de densité acoustique (Di) pour le cycle élémentaire courant, une étape de calcul d'une valeur de densité acoustique lissée ($\overline{D}_i$) correspondant à une moyenne des N valeurs de densité acoustique les plus récentes et dans lequel la valeur de densité acoustique lissée est mémorisée dans la base de données et/ou utilisée pour le calcul de l'état de santé.

8.  Procédé selon l'une des revendications précédentes, dans lequel ledit au moins un paramètre d'un signal acoustique est pris parmi la liste suivante :

    - amplitude du signal acoustique;
    - énergie du signal acoustique;
    - temps de montée du signal acoustique ;
    - fréquence des oscillations du signal acoustique;
    - durée du signal acoustique ;
    - nombre de « coups » dans le signal acoustique, un coup correspondant à un dépassement d'un seuil ;
    - fréquence des coups acoustiques, c'est-à-dire nombre de coups acoustiques par unité de temps dans le signal acoustique ;
    - présence d'un événement acoustique.

9.  Procédé selon la revendication 8, dans lequel la valeur de densité (Di) correspond à une somme des valeurs dudit au moins un paramètre du signal acoustique.

**Patentansprüche**

1. Verfahren zum Ermitteln des Gesundheitszustands einer Batterie (1) mit einem Sensor (3) der akustischen Aktivität der Batterie, umfassend die folgenden Schritte:

   - Erfassen von wenigstens einem akustischen Ereignis durch den Sensor während eines elementaren Verwendungszyklus der Batterie entsprechend einer Verwendungsperiode der Batterie mit Lade- und/oder Entladevorgängen;
   - Ermitteln des Werts von wenigstens einem Parameter (P) für jedes während des elementaren Verwendungszyklus erfasste akustische Signal;
   - Berechnen eines akustischen Dichtewerts (D oder $\overline{D}_i$) für den elementaren Verwendungszyklus nach einer Dichteberechnungsfunktion unter Berücksichtigung des wenigstens einen für jedes der während des Zyklus erfassten akustischen Signale ermittelten Parameters (P), wobei die Dichteberechnungsfunktion eine monotone Funktion entsprechend der Zahl von während des elementaren Zyklus erfassten Ereignissen ist;
   - Berechnen eines Gesundheitszustandswerts entsprechend dem zuvor berechneten akustischen Dichtewert mit einer funktionalen Beziehung oder einer vorgegebenen Datenbank, die das Ermitteln des Gesundheitszustands für einen gegebenen akustischen Dichtewert ermöglicht.

2. Verfahren zum Charakterisieren einer Testbatterie mit einem Sensor der akustischen Aktivität der Testbatterie, umfassend mehrere aufeinanderfolgende Testvorgänge, die während aufeinanderfolgender elementarer Verwendungszyklen der Testbatterie durchgeführt werden, wobei jeder Testvorgang die folgenden Schritte umfasst:

   - Erfassen von wenigstens einem akustischen Ereignis durch den Sensor während eines elementaren Verwendungszyklus der Testbatterie entsprechend einer Verwendungsperiode der Testbatterie mit Lade- und/oder Entladevorgängen;
   - Ermitteln des Werts von wenigstens einem Parameter (P) für jedes während des elementaren Verwendungszyklus erfasste akustische Signal;
   - Ermitteln eines akustischen Dichtewerts (D oder $\overline{D}_i$) für den elementaren Verwendungszyklus nach einer Dichteberechnungsfunktion unter Berücksichtigung des wenigstens einen für jedes der während des Zyklus erfassten akustischen Signale ermittelten Parameters (P), wobei die Dichteberechnungsfunktion eine monotone Funktion entsprechend der Zahl von während des elementaren Zyklus erfassten Ereignissen ist;
   - Ermitteln des Gesundheitszustands der Testbatterie während oder am Ende des elementaren Zyklus;
   - Speichern des Gesundheitszustands (SOH) und des akustischen Dichtewerts (Di oder $\overline{D}_i$) wie zuvor für den betreffenden elementaren Zyklus ermittelt in einer Datenbank.

3. Verfahren zum Charakterisieren einer Testbatterie nach Anspruch 2, ferner umfassend einen Schritt zum Ermitteln einer funktionalen Beziehung, die das Ermitteln des Gesundheitszustands der Testbatterie für einen gegebenen akustischen Dichtewert mit der Datenbank ermöglicht.

4. Verfahren zum Ermitteln des Gesundheitszustands einer Batterie nach Anspruch 1, wobei das Berechnen eines Gesundheitszustandswerts entsprechend einem Dichtewert mit einer vorgegebenen Datenbank gemäß dem Verfahren zum Charakterisieren nach Anspruch 2 erfolgt.

5. Verfahren zum Ermitteln des Gesundheitszustands einer Batterie nach Anspruch 1, wobei das Berechnen eines Gesundheitszustandswerts entsprechend einem akustischen Dichtewert mit einer vorab definierten funktionalen Beziehung gemäß dem Verfahren zum Charakterisieren nach Anspruch 3 erfolgt.

6. Verfahren nach einem der vorhergehenden Ansprüche, wobei der wenigstens eine Parameter dem Erfassen eines akustischen Ereignisses entspricht und der für einen elementaren Zyklus definierte akustische Dichtewert (Di) der Zahl von während des Zyklus erfassten Ereignissen entspricht.

7. Verfahren nach einem der vorhergehenden Ansprüche, umfassend nach dem Schritt zum Ermitteln eines akustischen Dichtewerts (Di) für den laufenden elementaren Zyklus einen Schritt zum Berechnen eines geglätteten akustischen Dichtewerts ($\overline{D}_i$) entsprechend einem Mittel der N neuesten akustischen Dichtewerte, wobei der geglättete akustische Dichtewert in der Datenbank gespeichert und/oder zum Berechnen des Gesundheitszustands verwendet wird.

8. Verfahren nach einem der vorhergehenden Ansprüche, wobei der wenigstens eine Parameter eines akustischen Signals aus der folgenden Liste gewählt wird:

   - Amplitude des akustischen Signals;
   - Energie des akustischen Signals;

- Anstiegszeit des akustischen Signals;
- Frequenz der Schwingungen des akustischen Signals;
- Dauer des akustischen Signals;
- Zahl der "Schläge" im akustischen Signal, wobei ein Schlag einem Überschreiten einer Schwelle entspricht;
- Frequenz der akustischen Schläge, das heißt Anzahl der akustischen Schläge pro Zeiteinheit im akustischen Signal;
- Vorliegen eines akustischen Ereignisses.

9. Verfahren nach Anspruch 8, wobei der Dichtewert (Di) einer Summe der Werte des wenigstens einen Parameters des akustischen Signals entspricht.

**Claims**

1. Method for determining the state of health of a battery (1), using a sensor (3) of the acoustic activity of the battery, comprising the following steps:

   - detection of at least one acoustic event by the sensor in the course of an elementary cycle of use of the battery, corresponding to a period of use of the battery with charging and/or discharging operations;
   - determination of the value of at least one parameter (P) for each acoustic signal detected in the course of the elementary cycle of use;
   - calculation, for the elementary cycle of use, of a value of acoustic density (D or $\overline{D}_i$) according to a density calculation function taking into account said at least one parameter (P) determined for each of the acoustic signals detected in the course of the cycle, the density calculation function being a monotonic function based on the number of events detected during the elementary cycle;
   - calculation of a state of health value corresponding to said previously calculated acoustic density value, on the basis of a functional relation or a predetermined database, making it possible to know the state of health for a given acoustic density value.

2. Method for characterizing a test battery, using a sensor of the acoustic activity of the test battery, comprising a number of successive test operations performed during successive elementary cycles of use of the test battery, each test operation comprising the following steps:

   - detection of at least one acoustic event by the sensor in the course of an elementary cycle of use of the test battery, corresponding to a period of use of the test battery with charging and/or discharging operations;
   - determination of the value of at least one parameter (P) for each acoustic signal detected in the course of the elementary cycle of use;
   - determination, for the elementary cycle of use, of a value of acoustic density (D or $\overline{D}_i$) according to a density calculation function taking into account said at least one parameter (P) determined for each of the acoustic signals detected in the course of the cycle, the density calculation function being a monotonic function based on the number of events detected during the elementary cycle;
   - determination, in the course of the elementary cycle or at the end thereof, of the state of health of the test battery;
   - storage in a database of the state of health (SOH) and the acoustic density value (Di or $\overline{D}_i$) determined previously for the elementary cycle concerned.

3. Method for characterizing a test battery according to Claim 2, further comprising a step of determining a functional relation which makes it possible to know the state of health of the test battery for a given acoustic density value, based on said database.

4. Method for determining the state of health of a battery according to Claim 1, wherein the calculation of a state of health value corresponding to an acoustic density value is carried out on the basis of a predefined database, according to the characterization method of Claim 2.

5. Method for determining the state of health of a battery according to Claim 1, wherein the calculation of a state of health value corresponding to an acoustic density value is carried out on the basis of a predefined functional relation according to the characterization method of Claim 3.

6. Method according to any of the preceding claims, wherein said at least one parameter corresponds to the detection of an acoustic event and the acoustic density value (Di) defined for an elementary cycle corresponds to the number of events detected during the cycle.

7. Method according to any of the preceding claims, comprising, following the step of determining an acoustic density value (Di) for the current elementary cycle, a step of calculating a smoothed acoustic density value ($\overline{D}_i$) corresponding to a mean of the N most recent acoustic density values, wherein the smoothed acoustic density value is stored in the database and/or used for the state of health calculation.

8. Method according to any of the preceding claims, wherein said at least one parameter of an acoustic signal is chosen from the following list:

   - amplitude of the acoustic signal;
   - energy of the acoustic signal;
   - rise time of the acoustic signal;
   - frequency of the oscillations of the acoustic signal;
   - duration of the acoustic signal;
   - number of "hits" in the acoustic signal, a hit corresponding to a passage beyond a threshold;
   - frequency of acoustic hits, that is to say the number of acoustic hits per unit of time in the acoustic signal;
   - presence of an acoustic event.

9. Method according to Claim 8, wherein the density value (Di) corresponds to a sum of the values of said at least one parameter of the acoustic signal.

## Fig. 1

Activité
acoustique

Année de fonctionnement (ou nombre de cycles équivalents)

Activité
acoustique

Année de fonctionnement (ou nombre de cycles équivalents)

## Fig. 2

Fig. 3A

Fig. 3B

Fig. 4

Fig. 5

Fig. 6

$$SOH(\%) = 0{,}0119\ \overline{Di} + 95{,}936$$

$$SOH(\%) = 0{,}5743\ \overline{Di} + 33{,}417$$

$\overline{Di}$ = Moyenne glissante des événements acoustiques

Fig. 7

Fig. 8

Fig. 9

```
                    ┌─────────┐
                    │  C = 0  │────── 100
                    └─────────┘
                         │
                         ▼
              ┌──────────────────────┐
              │  Détection événement │────── 110
              └──────────────────────┘
                         │
                         ▼
        ┌──────────────────────────────────┐
        │ Calcul paramètre caractéristique P │────── 120
        └──────────────────────────────────┘
                         │
                         ▼
              ┌──────────────────────┐
              │   Calcul densité D   │────── 130
              └──────────────────────┘
                         │
                         ▼
                        ╱╲
            NON        ╱    ╲
        ◄──────── Fin de cycle élémentaire ? ──── 140
                       ╲    ╱
                        ╲  ╱
                         ▼
                        OUI
                         │
                         ▼
              ┌──────────────────────┐
              │   Evaluation SOH     │────── 150
              └──────────────────────┘
                         │
                         ▼
                 ┌──────────────┐
                 │  Calcul D̄    │────── 160
                 └──────────────┘
                         │
                         ▼
        ┌──────────────────────────────────┐
        │ Mémorisation SOHᵢ ; Dᵢ ; D̄ᵢ pour cycle i │────── 170
        └──────────────────────────────────┘
                         │
                         ▼
        ┌──────────────────────────────────┐
        │ Définition relation entre SOH et D ou D̄ᵢ │────── 180
        └──────────────────────────────────┘
```

Fig. 10

Fig. 11

## RÉFÉRENCES CITÉES DANS LA DESCRIPTION

**Documents brevets cités dans la description**

- EP 2575205 A

**Littérature non-brevet citée dans la description**

- **NINA KIRCHEVA et al.** Acoustic Methods as a Tool for Management of Electrochemical Process of Energy. *30th European Conference on Acoustic Emission Testing & 7th International Conference on Acoustic Emission,* 12 Septembre 2012, 1-10